(19) Europäisches Patentamt

European Patent Office

Office européen des brevets

(11) **EP 4 261 616 A1**

(12) **EUROPEAN PATENT APPLICATION**

(43) Date of publication:
**18.10.2023   Bulletin 2023/42**

(51) International Patent Classification (IPC):
***G03F 7/20*** (2006.01)

(21) Application number: **22168094.5**

(22) Date of filing: **13.04.2022**

(52) Cooperative Patent Classification (CPC):
**G03F 7/70625; G03F 7/70508**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
- SU, Jing
  **San Jose, CA 95131 (US)**
- ZOU, Yi
  **San Jose, 95131 (US)**
- VAN MIERLO, Willem, Louis
  **5500 AH Veldhoven (NL)**
- VAN DER STRATEN, Koen, Wilhelmus, Cornelis, Adrianus
  **5500 AH Veldhoven (NL)**

- CAO, Peigen
  **San Jose, CA 95134 (US)**
- ENGBLOM, Peter, David
  **Hillsboro, 97124 (US)**
- DILLEN, Hermanus, Adrianus
  **5500 AH Veldhoven (NL)**
- SLACHTER, Abraham
  **5500 AH Veldhoven (NL)**
- TEL, Wim, Tjibbo
  **5500 AH Veldhoven (NL)**
- NECHAEV, Konstantin, Sergeevich
  **5500 AH Veldhoven (NL)**
- ANUNCIADO, Roy
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD AND COMPUTER PROGRAM FOR GROUPING PATTERN FEATURES OF A SUBSTANTIALLY IRREGULAR PATTERN LAYOUT**

(57)     A method of grouping pattern features of a substantially irregular pattern layout for patterning a substrate in a lithographic process. The method comprises obtaining at least one substantially irregular pattern representation, each at least one substantially irregular pattern representation relating to a respective layer of interest; grouping a plurality of pattern features comprised within the substantially irregular pattern representation based on geometry and/or at least one processing attribute relating to processing performance into a plurality of groups, each group comprising a plurality of pattern features which are similar in terms of geometry and/or the at least one processing attribute; and deriving a parameter of interest associated with one or more groups of the plurality of groups.

Fig. 3

EP 4 261 616 A1

**Description**

<u>FIELD</u>

The present description relates to methods and apparatus for applying patterns to a substrate in a lithographic process.

<u>BACKGROUND</u>

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, one or more parameters of the patterned substrate are measured. The one or more parameters may include, for example, the overlay error between successive layers formed in or on the patterned substrate and/or critical linewidth or critical dimension (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools.

<u>SUMMARY</u>

A significant metric in evaluating patterning performance is edge placement error (EPE). The position of the edge of a feature is determined by the feature's lateral position (overlay) and the size of the feature (CD). Part of this is very local and stochastic in nature, e.g., dependent on local overlay (LOVL) and local CD uniformity (LCDU). Also, line edge roughness (LER) and line width roughness (LWR) may result in very local CD variations. All of these may be contributors to the EPE performance.

EPE characterization and monitoring is very challenging for random logic layers due to the large pattern variation and low pattern repetition.

It is an object to provide, for example, improved methods for EPE applications for less repetitive or substantially irregular structures such as logic.

In an aspect, there is provided a method of grouping pattern features of a substantially irregular pattern representation for patterning a substrate in a lithographic process, the method comprising: obtaining at least one substantially irregular pattern representation, each at least one substantially irregular pattern representation relating to a respective layer of interest; grouping a plurality of pattern features comprised within the substantially irregular pattern representation based on geometry and/or at least one processing attribute relating to processing performance into a plurality of groups, each group comprising a plurality of pattern features which are similar in terms of geometry and/or the at least one processing attribute; and deriving a parameter of interest associated with one or more groups of the plurality of groups.

In an aspect, there is provided a computing apparatus comprising a processor, and being configured to perform a method as described herein.

In an aspect, there is provided a computer program comprising program instructions operable to perform a method as described herein when run on a suitable apparatus.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for devices such as semiconductor devices;

Figures 2(a) and (b) schematically depict two examples of stochastic variation: Figure 2(a) schematically depicts line edge roughness (LER) and Figure 2(b) schematically depicts line width roughness (LWR);

Figure 3 is a flowchart describing a method according to an embodiment;

Figure 4 is a schematic illustration of a feature on a patterning device (e.g., mask), and corresponding intensity plot on the substrate;

Figure 5 is a flowchart describing a method according to an embodiment; and

Figure 6 is a schematic illustration of the concept of EPE margin and corresponding CDF plots for two feature edges.

Figure 7 is a flowchart describing a method according to an embodiment wherein processing attribute data corresponding to pattern features is reduced in dimensionality before being clustered based on similarity.

Figure 8 depicts a method of agglomerative hierarchical clustering according to an embodiment of the invention.

DETAILED DESCRIPTION

Before describing embodiments of the invention in detail, it is instructive to present an example environment in which embodiments of the present invention may be implemented.

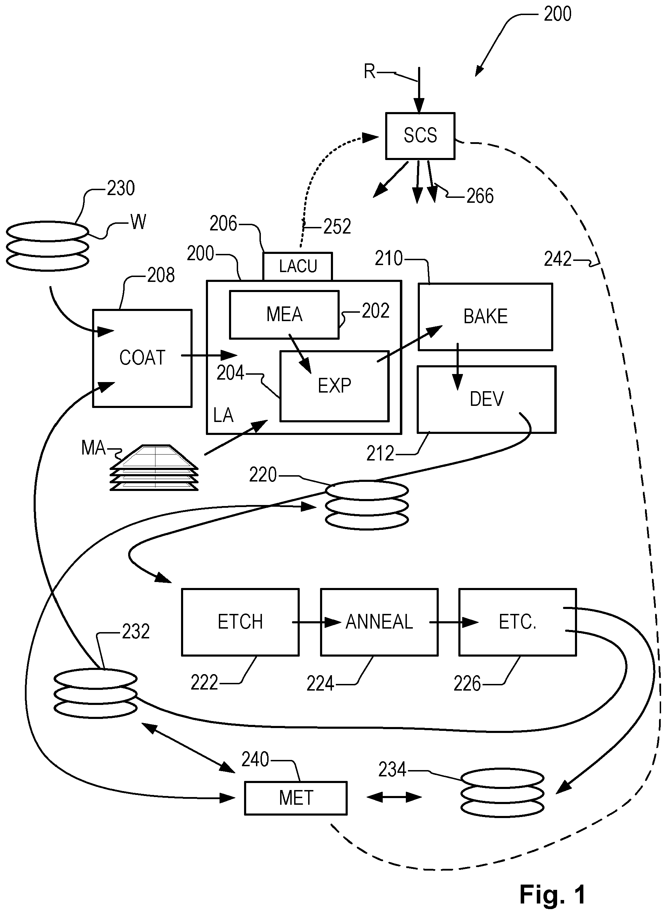

Figure 1 at 200 shows a lithographic apparatus LA as part of an industrial production facility implementing a high-volume, lithographic manufacturing process. In the present example, the manufacturing process is adapted for the manufacture of devices or other physical products, such as semiconductor products (integrated circuits) on substrates (such as semiconductor wafers). The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure typically involves a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers typically involve different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Another example of a metrology station is a scanning electron microscope (SEM), otherwise referred to as an electron beam (e-beam) metrology device, which may be included in addition to, or as an alternative to, a scatterometer. As such, metrology apparatus 240 may comprise an e-beam or SEM metrology device, either alone or in addition to a scatterometer. E-beam and SEM metrology devices have the advantage of measuring features directly (i.e., they directly image the features), rather than the indirect measurement techniques used in scatterometry (where parameter values are determined from reconstruction from and/or asymmetry in diffraction orders of radiation diffracted by the structure being measured). The main disadvantage with e-beam or SEM metrology devices is their measurement speed, which is much slower than scatterometry, limiting their potential application to specific offline monitoring processes.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Lithographic projection apparatuses typically project a patterned (i.e., by a reticle) image at a point immediately above the substrate, and then ultimately into the resist. The projected image is called the aerial image, which comprises a distribution of radiation intensity as a function of spatial position in the image plane. The aerial image is the source of the information that is exposed into the resist, forming a gradient in dissolution rates that enables the three-dimensional resist image to appear during development.

Stochastic induced failure predictions are typically made based on one or more stochastic metrics. Such one or more stochastic metrics may include stochastic measurements on the variation of one or more dimensional parameters; e.g. one or more selected from: CD (so called local CD uniformity (LCDU)), line edge position (so called line edge roughness (LER)), or linewidth (so called linewidth roughness (LWR)), for example. Accurate measurement of the number of failures is cumbersome, as low failure rates (e.g., of the order of 1 per million to 1 per billion) can be expected in an optimized process.

Imaging, using a lithographic projection apparatus, will result in a stochastic variation in one or more parameters, such as pronounced line width roughness (LWR) and/or local CD variation in small two-dimensional features such as holes. The stochastic variation may be attributed to factors such as photon shot noise, photon-generated secondary electrons, photon absorption variation, photon-generated acids in the resist. In the case of EUV lithography, the small sizes of features for which EUV is called for further compound this stochastic variation. The stochastic variation in smaller features are a significant factor in production yield and justifies inclusion in a variety of optimization processes of the lithographic projection apparatus.

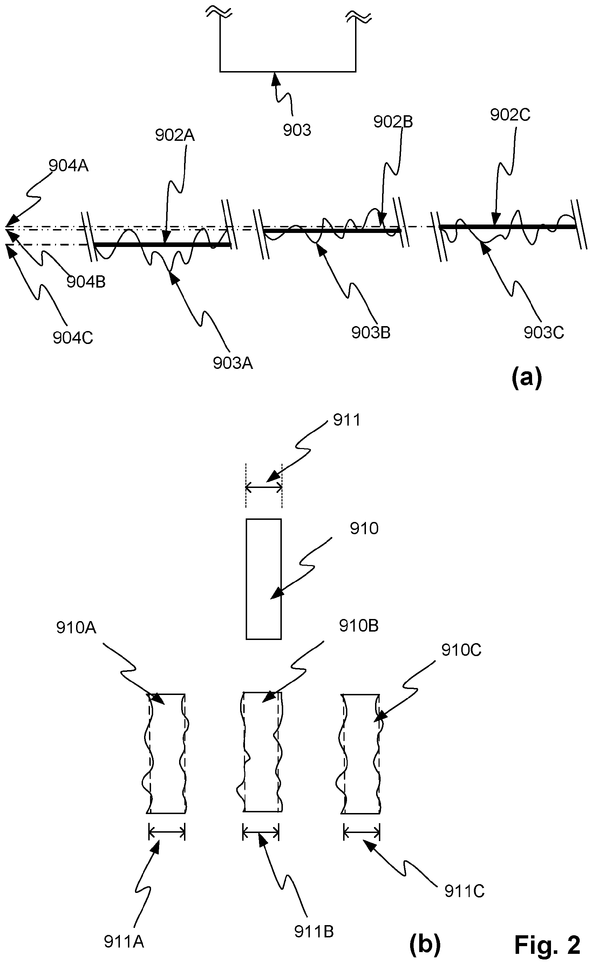

Figure 2(a) schematically depicts a stochastic effect - line edge roughness (LER). Assuming all conditions are identical in three exposures or simulations of exposure of an edge 903 of a feature on a design layout, the resist images 903A, 903B and 903C of the edge 903 may have slightly different shapes and locations. Locations 904A, 904B and 904C of the resist images 903A, 903B and 903C may be measured by averaging the resist images 903A, 903B and 903C, respectively. LER of the edge 903 may be a measure of the spatial distribution of the locations 904A, 904B and 904C. For example, the LER may be a $3\sigma$ of the spatial distribution (assuming the distribution is a normal distribution). The LER may be derived from many exposures or simulation of the edge 903.

Figure 2(b) schematically depicts line width roughness (LWR). Assuming all conditions are identical in three exposures or simulations of exposure of a long rectangle feature 910 with a width 911 on a design layout, the resist images 910A, 910B and 910C of the rectangle feature 910 may have slightly different widths 911A, 911B and 911C, respectively. LWR of the rectangle feature 910 may be a measure of the distribution of the widths 911A, 911B and 911C. For example, the LWR may be a $3\sigma$ of the distribution (assuming the distribution is a normal distribution). The LWR may be derived from many exposures or simulation of the rectangle feature 910. In the context of a short feature (e.g., a contact hole), the widths of its images are not well defined because long edges are not available for averaging their locations. A similar quantity, LCDU, may be used to characterize stochastic variation. The LCDU is a $3\sigma$ of the distribution (assuming the distribution is a normal distribution) of measured CDs of images of the feature.

In order to monitor the patterning process (e.g., a device manufacturing process) that includes at least one pattern transfer step (e.g., an optical lithography step), the patterned substrate is inspected and one or more parameters of the patterned substrate are measured / determined. The one or more parameters may include, for example, overlay between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberration of an optical lithography step, placement error (e.g., edge placement error), etc. This measurement may be performed on a target of the product substrate itself and/or on a dedicated metrology target provided on the substrate. The measurement can be performed after-development of a resist but before etching or can be performed after-etch.

In an embodiment, a parameter obtained from a measurement process is a parameter derived from a parameter determined directly from the measurement process. As an example, a derived parameter obtained from a measurement parameter is edge placement error (EPE) for the patterning process. The edge placement error provides a variation in the location of an edge of a structure created by the patterning process. In an embodiment, the edge placement error is derived from an overlay value. In an embodiment, the edge placement error is derived from a combination of an overlay value and at least one stochastic metric. In an embodiment, the edge placement is derived from a combination of an overlay value, at least one CD stochastic metric value (e.g., CDU, LCDU) and (optionally) another stochastic metric (e.g., edge roughness, shape asymmetry, etc. of the individual structures). In an embodiment, the edge placement error comprises an extreme value (e.g., 3 standard deviation, i.e., $3\sigma$) of overlay and CD errors combined. In an embodiment, the edge placement error may comprise the following form, although other formulations are possible providing that at least an overlay value and at least one CD stochastic metric are included:

$$\sqrt{\left(3\sigma_{overlay}\right)^2 + \left(\frac{3\sigma_{CDU}}{2}\right)^2 + \frac{3\sigma_{OPE.PBA}}{2} + \frac{6\sigma_{LER,LPE}}{\sqrt{2}}}$$

wherein $\sigma_{overlay}$ corresponds to the standard deviation of overlay, $\sigma_{CDU}$ corresponds to the standard deviation of the critical dimension uniformity (CDU) of structures created in the patterning process, $\sigma_{OPE.PBA}$ corresponds to the standard deviation of optical proximity effects (OPE) and/or proximity bias average (PBA) which is a difference between CD at pitch to a reference CD, and $\sigma_{LER,LPE}$ corresponds to the standard deviation of line edge roughness (LER) and/or local placement error (LPE). While the formulation above is in relation to standard deviation, it can be formulated in a different comparable statistical manner, such as variance. As such, the term edge placement error is not limited to any specific formulation, but rather is a general term relating to feature and/or edge position.

There are various techniques for making measurements of the structures formed in the patterning process, including the use of a scanning electron microscope, an image-based measurement tool and/or various specialized tools. As discussed above, a fast and non-invasive form of specialized metrology tool is one in which a beam of radiation is directed onto a target on the surface of the substrate and properties of the scattered (diffracted/reflected) beam are measured. By evaluating one or more properties of the radiation scattered by the substrate, one or more properties of the substrate can be determined. This may be termed diffraction-based metrology. One such application of this diffraction-based metrology is in the measurement of feature asymmetry within a target. This can be used as a measure of overlay, for example, but other applications are also known. For example, asymmetry can be measured by comparing opposite parts of the diffraction spectrum (for example, comparing the -1st and +1st orders in the diffraction spectrum of a periodic grating). This can be done as described, for example, in U.S. Patent Application Publication US2006-066855, which is incorporated herein in its entirety by reference. Another application of diffraction-based metrology is in the measurement of feature width (CD) within a target.

Many of the known EPE applications presently used are predominately suitable for memory use cases, i.e., where there is significant repetition in the exposed pattern(s). For example, process window metrology (PWM) can be used to determine a focus/dose (or other parameter) set point from a measured stochastic process window, where a process window describes a process space in terms of one or more parameter values within which predicted quality is acceptable (e.g., the probability of defect is below an acceptability threshold). More specifically, the process window of a feature describes ranges of processing parameters of a device manufacturing process (e.g., lithography, etching) under which the feature will be expected to be produced within specifications. Specifications may mean acceptable ranges of characteristics of the feature produced by the device manufacturing process. Examples of specifications include checks for necking, line pull back, line thinning, CD, edge placement, overlapping, resist top loss, resist undercut and/or bridging. As such, the process window describes ranges of acceptable values of processing parameters. A value being acceptable here means if the feature is produced under that value, the feature is expected not to become a defect. To obtain a measured stochastic process window, there should be sufficient repetitions of each feature (or at least each hotspot) to obtain sufficient stochastic data.

Particular features or regions within a pattern which have a small process window are sometimes referred to as hotspots or process window limiting features, and process window metrology aims to identify these hotspots and characterize the process window. The process windows for these hotspots (and possibly for other features of the pattern) can then be "overlapped" to obtain an overall overlapping process window for an exposure or a portion thereof. Such an overlapping process window may comprise the common portion of all relevant process windows for a pattern to be exposed. A process window may be multi-dimensional depending on the relevant parameters (e.g., one or more selected from focus, dose, overlay, CD). Methods relating to process window monitoring may be found, for example, in U.S. Patent No. US7695876 and PCT Patent Application Publication No. WO2016045901, each of which is incorporated herein in its entirety by reference.

The concept of a stochastic process window, for example which comprise specifications based on stochastic failure rate, are described in PCT Patent Application Publication No. WO2020/169355, which is incorporated herein in its entirety by reference. This document discloses, for example, a method of determining a characteristic of one or more processes for manufacturing features on a substrate, the method including: obtaining image data of a plurality of features on a least part of at least one region on a substrate; using the image data to obtain measured data of one or more dimensions of each of at least some of the plurality of features; determining a statistical parameter that is dependent on the variation of the measured data of one or more dimensions of each of at least some of the plurality of features; determining a probability of defective manufacture of features in dependence on a determined number of defective features in the image data; and determining the characteristic of the one or more processes to have the probability of defective manufacture of features and the statistical parameter.

As another example, edge placement error simulation may combine two-layer (or two pattern step) edge placement variability and overlay metrology to determine a final effective EPE, which can be used for process monitoring and control. This approach works well for layers with highly repetitive structures, such as memory structures, because the number of unique features is limited and each feature can be measured over a sufficient number of examples to capture the stochastic effect. As such, edge placement error simulation supports such memory use cases, where a unit cell repeats many times in a measured SEM image. For each layer, the unit cell may be extracted from the SEM image and contour stacking performed to obtain a pattern probability map (or stochastic EPE (SEPE) map). Contour stacking may comprise plotting the printed contours of multiple instances of a repeated feature on a common plot (i.e., stacking them on an x/y plot) to represent the contour variability for that feature. This can be done for two relevant layers, and the resultant two pattern probability maps/SEPE maps are then combined to form a local EPE map. Such an approach may also apply to single layer double-patterning processes. This local EPE map can in turn be combined with a global overlay map to construct a final EPE map. The final EPE map can be used to monitor a process or even to directly predict yield. Edge placement error simulation and/or contour stacking are described in PCT Patent Application Publication No. WO2020/094286, which is incorporated herein in its entirety by reference.

However, for random logic layers, a given SEM image typically comprises insufficient pattern repetition to enable contour stacking and obtain a local EPE map. Moreover an irregular logic layout typically has a large number of pattern variations, and therefore determining where to perform measurements is also an issue.

As such, EPE characterization and monitoring is very challenging for irregular logic layers due to this large pattern variation and low pattern repetition. Methods disclosed herein aim to address, for example, one or more issues for such non-repetitive structures to enable application of existing EPE solutions: 1) how to select critical patterns (or "gauges") from a pattern representation; and/or 2) how to group selected patterns or gauges to have sufficient repetition to capture the stochastic effect. A pattern representation may comprise a layout description or layout file and/or a sufficiently detailed image (e.g., SEM image) obtained with a sufficiently large field of view.

As such, methods disclosed herein comprise grouping of pattern features based on one or more parameters indicative of edge placement performance. This may comprise grouping of features based on geometry and/or at least one processing attribute relating to processing performance (e.g., edge placement performance).

The at least one processing attribute may comprise *inter alia* one or more selected from: a process window parameter (e.g., process window shape), image log slope, edge placement error, a process variation band (PV band), a stochastic edge placement error (SEPE) band, image contrast, peak intensity, integrated intensity (e.g., over a certain region such as a printed contour), and/or mask error enhancement-factor (MEEF) which describes the ratio of substrate or resist CD error to mask CD error. Following this grouping, a step of performing metrology (e.g., stochastic metrology) on one or more selected groups (e.g., critical groups) is performed (e.g., to obtain measured stochastic data for the one or more selected groups.

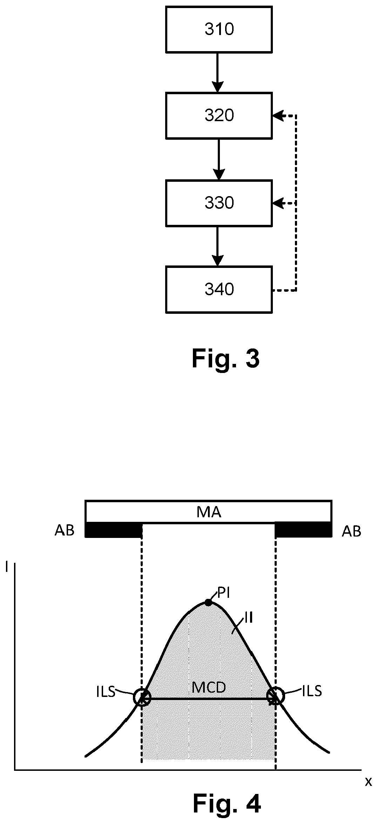

Figure 3 is a flow diagram describing a proposed method for such logic (or any largely non-repetitive structure) use cases. At step 310, a critical gauge selection and geometry based grouping is performed. Given a suitable substantially irregular pattern representation (e.g., full chip layout description and/or suitably detailed image from a tool (e.g., SEM) with a large field of view from which the layout can be determined), heuristics may be developed to identify critical locations or hotspots most likely to provide potential EPE problems. The heuristics may comprise one or a combination of: geometry based layout analysis and/or lithography model based patterning simulation. For example, a geometry based analysis may comprise analyzing the full-chip layout, and placing gauges at locations or features where the design indicates tight tolerances, e.g., comprises small target line/space CD, tip-to-tip distance and/or where interlayer connection occurs.

Model based approaches may comprise simulation of the substrate image and contours by using one or more lithography models and detecting weak lithography spots, e.g., based on indicators such as image log slope (ILS), PV band, etc. For example, the ILS for a pattern or gauge describes the log slope (log intensity with position) of the exposure intensity at a (nominal) feature edge position. The resultant latent image quality (e.g., at this edge position) is known to be essentially directly proportional to this ILS. The ILS may be calculated based on a (simulated) image of the gauge pattern; a small ILS indicates a relatively blurry image and a large ILS indicates a clearer image.

A PV band describes a representation of the extent of the variation in (e.g., simulated and/or measured) contours, e.g., as stacked, resultant from variations in one or more certain process parameters. The area described by the position variation of the combined multiple contours make a PV band. A PV band shows how much and where a design will vary in response to process variation.

Optionally, the gauges can be selected, validated and refined by using a stochastic edge placement error (SEPE) model, or the gauges selected by heuristics may be validated and refined by using a stochastic edge placement error (SEPE) model. Stochastic edge placement error methods are described, for example, in PCT Patent Application Publication Nos. WO2020/173654, WO2021/037484 and WO2020/233950, which are incorporated herein in their entireties by reference. For example, in WO2021/037484, SEPE may be determined from a pattern probability image which describes multi-dimensional variability in shapes of features. Such a pattern probability image comprises predicted probabilities of a two-dimensional substrate geometry for the feature and may comprise a plurality of stacked images comprising predicted probabilities of two-dimensional feature geometry. The different predicted probabilities across a predicted probability band of a feature edge of the pattern probability image provides an indication of how the location of the edge may vary across a pattern. The stochastic variation or band (also called stochastic edge placement error band or SEPE band) may be determined from the predicted probability gradient of this predicted probability band. The SEPE band may result from uncertainty in the number of photons, uncertainty in the number of generated acid with the photons, and/or one or more other resist development related effects, for example.

In another method, the SEPE band can be extracted by a decomposition method, e.g., based on a linear nested model and/or a method disclosed in WO2020/233950. For example, a feature's local critical dimension uniformity (LCDU) or local edge placement uniformity (LEPU) has three contributions including SEM noise, patterning device (mask) error, and SEPE band. As such, LCDU or LEPU data, e.g., can be decomposed into the three contributions. Such LEPU/LCDU data or other stochastic metric data can be obtained from overlapped SEM images for example.

After gauge selection, a geometry based grouping may be performed. This step may comprise defining, for example, a pattern radius or a pattern area (e.g., a few hundred nm for EUV layers). If gauges have similar geometry environment within the given radius/area, they can be merged into a single group and considered as one pattern.

This can be achieved using a suitable pattern search method and a pattern grouping method. The pattern search method may be used to find all patterns in the layout that are equal or similar in terms of geometry to a given seeding pattern or a set of seeding patterns. The pattern grouping method may be used to cluster a set of patterns into groups so that patterns are equal or similar in terms of geometry within each group. In each case, the concept of "similarity" may be defined by a user, e.g., by setting one or more tolerances or what determines a match.

After this geometric grouping step, should the group number be sufficiently limited and each group have sufficient repetition, it may be possible to proceed directly to step 340, without performing steps 320 and 330. However this is not likely to be the case for most logic patterns which typically lack sufficient repetition for geometry based grouping to be enough. Because of this, steps 320 and 330 are proposed to further merge groups, so as to reduce their number and increase pattern counts in each group.

Step 320 is a processing attribute extraction step. A non-exhaustive list of example one or more processing attributes which may be extracted in this step has been provided above. Any processing attribute which can describe lithography or exposure behavior of each gauge or pattern may be used. Each of the one or more processing attributes may be simulated using one or more computational lithography models and/or measured directly by experiment. Figure 4 illustrates some of the possible processing attributes relating to a single line feature having patterning device (mask) CD MCD (as defined by the patterning device MA and absorber pattern AB). Below this is a corresponding plot of exposure intensity I against x (or y). MEEF describes the CD error and may be, in a specific example, the ratio of the patterning device CD to the CD on resist. Other processing attributes include the peak intensity PI, integrated intensity II (represented by the shaded area) and ILS (intensity slope at a feature edge) or EPE. As already stated, one or more other processing attributes not represented here may include the process window shape, PV band, image contrast or SEPE band.

Step 330 comprises a processing attribute pattern grouping step. Once the one or more processing attributes have been identified, any suitable clustering or grouping methods or algorithms may be employed to do the processing attribute pattern grouping. For example, clustering algorithms such as k-Means, density-based spatial clustering of applications with noise (DBSCAN), and/or hierarchical clustering may be used. Other approaches may include using one or more regression models, such as linear regression and/or a regression tree.

This step may also comprise a grouping qualification step to qualify the grouping. Such a step may use one or more suitable key performance indicators (KPIs) to quantify how good the grouping is. One example KPI is an intra-group and inter-group process parameter (e.g., CD/EPE) distribution difference (may be done on patterns with enough repetition). The goal of grouping is to minimize or reduce intra-group difference while maximizing or increasing inter-group difference.

Step 340 may comprise a metrology step. Such a step may comprise performing massive metrology measurement. This step may be performed to validate the grouping and for one or more downstream EPE applications. To validate grouping effectiveness experimentally, a proper subset of the groups may be selected (e.g., groups identified as critical or having a small process window) and one or more gauges (e.g., hotspots) sampled from the selected groups for substrate measurement. For example all groups or a subset of groups may be so selected based on metrology budget. Group selection criteria may comprise one or more selected from: 1) groups with small process window, 2) groups with large EPE variation, 3) groups with small mean CD or other suitable parameter, etc. By checking the similarity of the one or more final application metrics (e.g., failure rate for PWM), the quality of the grouping can be determined. Should a pattern of interest not have enough repeats, a test patterning device (mask) comprising many repetitions of this pattern of interest may be exposed and measured.

Finally, for a downstream application, only the most critical groups could be selected. For each critical group, only one or a limited number of critical patterns can be measured as it can be assumed that all the patterns of each group will behave (e.g., in terms of EPE) in a similar fashion. This allows existing EPE solutions to be directly applied to irregular logic use cases, which presently rely on measuring only a small subset of (essentially similar repetitive) structures and assuming that they will behave the same way.

Note that, based on the metrology of step 340 (e.g., if it indicates that the grouping is non-optimal and can be improved), the method may return back to steps 320 and/or 330.

In the above, it was described that critical gauges or hotspots may be determined using a SEPE model, before performing a geometric gauge grouping, e.g., by using pattern recognition and pattern optimization techniques (pattern grouping and/or pattern searching). It was also mentioned that present edge placement error simulation techniques are only suitable for sufficiently repetitive patterns. An embodiment will now be described which extends such edge placement error simulation techniques to less-repetitive or irregular logic patterns. The method comprises using the aforementioned SEPE modeling and a trained lithography manufacturability check (LMC) model to identify critical gauges, and then perform a geometric gauge grouping of the identified critical gauges as has been described. A LMC model may comprise a model determined from (e.g., simulated) SEM/image data including known defects to predict defects or defect probability based on the resist image (or etch image). As such, a LMC model can be used to find hotspots and defects by defining different types of detectors to check the substrate image/contour, which may be obtained from simulation using a lithographic model and/or SEPE model. LMC modeling is described, for example, in PCT Patent Application Publication No. WO2019-162346, which is hereby incorporated in its entirety by reference.

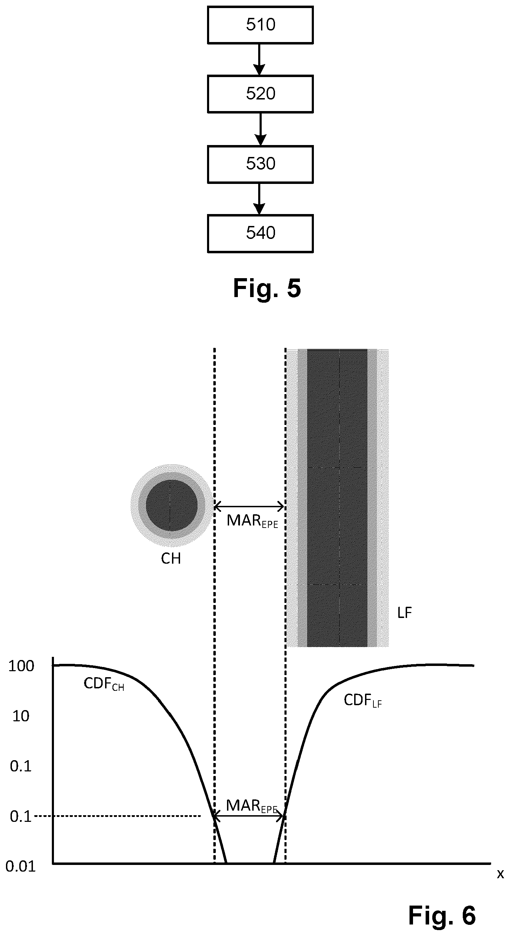

Figure 5 is a flowchart describing such a method. In step 510, a SEPE model for the relevant layer or layers is/are calibrated and validated. The SEPE model can be used to predict a SEPE band from simulated aerial images for a full-chip layout. There is an established way to calibrate and validate a SEPE model. Where there are two layers of interest, an independent SEPE model for each layer is constructed. The SEPE model can be extended to capture the full CD/EPE distribution by predicting high order momenta such as skew and/or kurtosis. Methods for SEPE modeling are disclosed, for example, in the aforementioned documents WO2020/173654, WO2021/037484 and WO2020/233950.

Step 520 is a critical gauge or pattern feature identification step. This comprises (in a two-layer example) applying the SEPE models to both layers of interest separately to obtain the EPE distribution (e.g., as a cumulative distribution function (CDF)) for all edge positions in full-chip layouts of both layers. Obviously, in a single layer example, the SEPE model is applied to this single layer. Following this, stochastic hotspots can be determined, e.g., using one or more LMC detectors.

Figure 6 illustrates step 520 with a (single layer or) dual layer bridging example. Shown are two features: contact hole CH and line feature LF, with shading to illustrate the SEPE distribution at each relevant edge. Below this are CDF plots $CDF_{CH}$, $CDF_{LF}$ for the edge positions at the closest point of these features. The contact hole CH and line feature LF may each be in a different layer, or they may be in the same layer.

This step may comprise calculating the EPE margin $MAR_{EPE}$ of pattern configurations or gauges corresponding to a particular CDF probability (e.g., a user chosen CDF probability threshold). In the example shown here, the CDF probability threshold is 0.1%. The EPE margin $MAR_{EPE}$ of the pattern configurations or gauges at this probability threshold can then be calculated and compared to an EPE margin threshold (e.g., 10 nm). Pattern configurations which have a smaller EPE margin than this margin threshold can be deemed to be critical gauges.

Step 530 may comprise a critical gauge grouping and ranking step. The gauge severity can be ranked by EPE margin size. However, the severity of a stochastic hotspot not only relates to its EPE margin but also depends to how many times it is repeated. If a pattern has a very low occurrence on full chip layout, it might not be problematic even if it has a small EPE margin. Therefore it is proposed, in an embodiment, to use the aforementioned pattern search application to find all such (e.g., dual layer) patterns from the full chip layout and then re-rank gauges in terms of both EPE size and pattern occurrence. After ranking, one or more patterns/gauges out of the ranked gauges may be selected (e.g., the top N patterns, where N is any integer) and used in edge placement error simulation for EPE characterization, monitoring and control.

Step 540 comprises a local EPE map construction step. Two example methods will be provided for constructing the local EPE map: simulation and experiment. If confidence on SEPE model accuracy is high, the simulated EPE margin, e.g., using one or more local process parameters (e.g., focus, dose, etc.), may be used to directly form the local EPE map. However, where confidence on the SEPE model is lower (while still sufficient for critical gauge identification) and/or the process has slightly drifted, then substrate metrology may be performed to obtain the local EPE map.

To obtain an accurate EPE CDF experimentally, there should be sufficient sampling for each edge, which can be done by geometric grouping of each edge separately on its corresponding layer. The geometric grouping in step 530, by contrast, is a dual layer grouping and thus each group may not have as many repeats as on each individual layer. If geometric grouping is not sufficient, a further grouping based on lithography behavior similarity (processing attributes), as has been described, may be performed.

As described in previous paragraphs the processing attribute data associated with the various pattern features is used to divide (cluster) the pattern features into groups (clusters) sharing a certain common behaviour. However in case the processing attribute data has a large volume (due to the high number of different features and/or processing attributes) the step of clustering may be challenging in view of required computational time and data storage. In addition collinearity and bias between the clusters due to redundancy present within the processing attribute data may prevent efficient and accurate clustering of the pattern features. It is hence proposed to reduce the dimensionality of the processing attribute data before applying the clustering step, e.g. the clustering is performed on the processing attribute data as represented in a lower dimensional space. The advantage of this is that the data set size is reduced (less computational effort and required data storage size) and redundancy within the data set will be (strongly) reduced. Additionally the clusters within the reduced dimensionality space will be easier to visualize (and hence improve interpretation by the user).

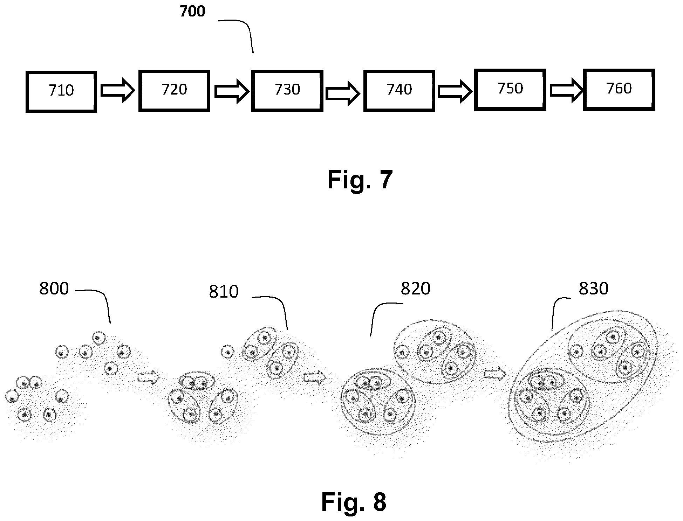

Figure 7 depicts an embodiment 700 of the invention wherein, as described above, the clustering of pattern features is preceded by a data (dimensionality) reduction step. In step 710 the pattern features of interest are selected, for example based on domain knowledge or empirically observed relevance of particular features. In step 720 the associated processing attribute data is inventoried. The parameters comprised within the processing attribute data are represented in a space having a dimension which is (substantially) lower than the number of parameters comprised within the processing attribute data in step 730. The data dimensionality reduction technique may be any suitable technique, for example one of: Principal Component Analysis (PCA), Singular Value Decomposition (SVD), using encoder-decoder techniques (for example Variable Auto-Encoder) or tSNE (non-linear mapping) techniques.

The processing attribute data as represented in the lower dimension space is subsequently clustered using any suitable clustering algorithm, such as k-Means, density-based spatial clustering, and/or hierarchical clustering. Other approaches may include using one or more regression models, such as linear regression and/or a regression tree. Step 740, 750 and 760 as depicted in figure 7 provide an example of a hierarchical clustering technique. In step 740 similarity of the data within the reduced dimensionality space is determined. In step 750 distances (for example Euclidean distances) between data points are determined. In step 760 the clusters are determined using the determined similarities and distances.

Figure 8 depicts the result of the data dimensionality reduction and clustering steps applied to the processing attribute data, in this case based on agglomerative hierarchical clustering techniques. As shown the data associated with the various pattern features is initially represented in the lower dimensional space (interpretable visualization), as depicted by the data points 800 (each distinct pattern feature or pattern feature metric is a separate point). Subsequently agglomerative clustering steps 810, 820 and 830 are applied to result in a hierarchically clustered processing attribute data set, each cluster demonstrating a level of similarity between the different pattern features and/or pattern feature metrics. As a result the user can assess which pattern feature (metrics) are similar and to what extent. The hence obtained clustering of the pattern features can now be used in any previously described way of improved pattern (EPE) inspection and/or determination or verification of a certain parameter of interest (for example EPE) associated with the pattern. For example an advantage of the herein proposed methods of clustering within a lower dimensional parameter feature space is that the number of clusters is reduced (as redundancy and cluster bias is filtered out of the data) and as a result per cluster a larger volume of data (e.g. more pattern features enclosed in one cluster) is available providing a more accurate determination of a parameter of interest (such as EPE).

Further embodiments of the invention are disclosed in the list of numbered clauses below:

1. A method of grouping pattern features of a substantially irregular pattern representation for patterning a substrate in a lithographic process, the method comprising: obtaining at least one substantially irregular pattern representation, each at least one substantially irregular pattern representation relating to a respective layer of interest; grouping a plurality of pattern features comprised within the substantially irregular pattern representation based on geometry and/or at least one processing attribute relating to processing performance into a plurality of groups, each group comprising a plurality of pattern features which are similar in terms of geometry and/or the at least one processing attribute; and deriving a parameter of interest associated with one or more groups of the plurality of groups.

2. The method according to clause 1, wherein the grouping comprises at least grouping the pattern features based on at least one processing attribute.

3. The method according to clause 2, wherein the at least one processing attribute comprises one or more selected from: one or more process window parameters corresponding to each process feature, image log slope of a radiation intensity distribution at substrate level corresponding to each process feature, edge placement error corresponding to each process feature, a process variation band corresponding to each process feature, a stochastic edge placement error (SEPE) band corresponding to each process feature, image contrast corresponding to each process feature, peak intensity of the radiation intensity distribution corresponding to each process feature, integrated intensity of the radiation intensity distribution corresponding to each process feature, or mask error enhancement-factor corresponding to each process feature.

4. The method according to clause 2 or clause 3, wherein the grouping comprises: a first grouping for grouping the pattern features based on geometry; and a second grouping for grouping the pattern features based on the at least one processing attribute.

5. The method according to clause 4, wherein the second grouping step comprises applying a clustering algorithm.

6. The method according to clause 5, wherein the clustering algorithm comprises one or more of a: k-Means algorithm, a density-based spatial clustering of applications with noise (DBSCAN) algorithm or a hierarchical clustering algorithm.

7. The method according to clause 4, 5 or 6 wherein the second grouping step comprises applying one or more regression models and/or regression trees.

8. The method according to any of clauses 4 to 7, comprising performing a validation step to qualify the result of the second grouping step based on intra-group distribution difference and inter-group distribution difference of at least one process parameter.

9. The method according to clause 8, wherein the at least one process parameter comprises critical dimension and/or edge placement error or other placement metric.

10. The method according to any of clauses 4 to 9, wherein the at least one processing attribute is extracted via metrology and/or simulation prior to the second grouping step.

11. The method according to any preceding clause, wherein the grouping step or first grouping step comprises: defining a pattern area; determining whether pattern feature have similar geometry within the pattern area; and grouping together those patterns which are determined to have similar geometry in the preceding step.

12. The method according to any preceding clause, wherein the grouping step or first grouping step comprises finding all pattern features in the pattern representation that are equal or similar in terms of geometry to a given seeding pattern or a set of seeding patterns.

13. The method according to any preceding clause, wherein the grouping is preceded by a critical pattern feature identification step for selecting the patterning features.

14. The method according to clause 13, wherein the critical pattern feature identification comprises: a geometry based layout analysis to identify pattern features having tolerances below a threshold; and/or a lithography model based patterning simulation which simulates lithography exposures based on the pattern feature, the critical pattern feature being identified within the simulation output.

15. The method according to clause 14, wherein the critical pattern feature identification comprises the lithography model based patterning simulation and wherein the lithography model based patterning simulation comprises determining a pattern feature as a critical pattern feature based on one or more selected from: image log slope, process variation band, stochastic edge placement error band, image contrast, peak intensity, integrated intensity.

16. The method according to any of clauses 13-15, wherein the critical pattern feature identification comprises identifying the critical pattern features using at least one stochastic edge placement error model.

17. The method according to clause 16, wherein the critical pattern feature identification comprises: determining a stochastic edge placement error model for each of one or a pair of layers of interest; applying separately each stochastic edge placement error model to a respective one of the layers of interest to obtain an edge placement error distribution for each model; and determining the pattern features as stochastic critical pattern features from the edge placement error distributions.

18. The method according to clause 17, wherein the determining the pattern features as stochastic critical pattern features comprises: determining an edge placement error margin for each pattern feature; and determining whether pattern configurations defined by pattern features in a pair of layers have a smaller edge placement error margin than a margin threshold.

19. The method according to clause 18, further comprising ranking severity of the pattern features by the edge placement error margin and number of occurrences in the representation(s).

20. The method according to clause 18 or clause 19, further comprising using the edge placement error margin to determine a local edge placement error map.

21. The method according to any preceding clause, wherein the parameter of interest comprises at least one process window parameter and/or at least one edge placement parameter.

22. The method according to any preceding clause, further comprising deriving a stochastic parameter based on assuming that all the pattern features of a group will behave similarly in terms of edge placement performance.

23. The method according to any preceding clause, further comprising:

identifying one or more of the groups as critical groups; and performing stochastic metrology on pattern features within the one or more critical groups to obtain measured stochastic data.

24. The method according to clause 23, comprising using the measured stochastic data to validate the quality of the grouping.

25. The method according to any preceding clause, wherein the pattern representation comprises a pattern layout and/or pattern image.

26. The method according to any preceding clause, further comprising performing process window metrology and/or computational edge placement error simulation using the groups of pattern features, where it is assumed that all the pattern features of a group will behave similarly in terms of edge placement performance.

27. A processing apparatus comprising a processor, and being configured to perform the method of any preceding clause.

28. A metrology apparatus being comprising the processing apparatus of clause 27.

29. A computer program comprising program instructions operable to perform the method of any of clauses 1 to 26, when run on a suitable apparatus.

30. A non-transient computer program carrier comprising the computer program of clause 29.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of grouping pattern features of a substantially irregular pattern representation for patterning a substrate in a lithographic process, the method comprising:

   obtaining at least one substantially irregular pattern representation, each at least one substantially irregular pattern representation relating to a respective layer of interest;
   grouping a plurality of pattern features comprised within the substantially irregular pattern representation based on geometry and/or at least one processing attribute relating to processing performance into a plurality of groups, each group comprising a plurality of pattern features which are similar in terms of geometry and/or the at least one processing attribute; and
   deriving a parameter of interest associated with one or more groups of the plurality of groups.

2. The method as claimed in claim 1, wherein the grouping comprises at least grouping the pattern features based on at least one processing attribute.

3. The method as claimed in claim 2, wherein the at least one processing attribute comprises one or more selected from: one or more process window parameters corresponding to each process feature, image log slope of a radiation intensity distribution at substrate level corresponding to each process feature, edge placement error corresponding to each process feature, a process variation band corresponding to each process feature, a stochastic edge placement error (SEPE) band corresponding to each process feature, image contrast corresponding to each process feature, peak intensity of the radiation intensity distribution corresponding to each process feature, integrated intensity of the radiation intensity distribution corresponding to each process feature, or mask error enhancement-factor corresponding to each process feature.

4. The method as claimed in claim 2 or claim 3, wherein the grouping comprises:

   a first grouping for grouping the pattern features based on geometry; and
   a second grouping for grouping the pattern features based on the at least one processing attribute.

5. The method as claimed in claim 4, wherein the second grouping step comprises applying a clustering algorithm.

6. The method as claimed in claim 5, wherein the clustering algorithm comprises one or more of a: k-Means algorithm, a density-based spatial clustering of applications with noise (DBSCAN) algorithm or a hierarchical clustering algorithm.

7. The method as claimed in claim 4, 5 or 6 wherein the second grouping step comprises applying one or more regression models and/or regression trees.

8. The method as claimed in any of claims 4 to 7, comprising performing a validation step to qualify the result of the second grouping step based on intra-group distribution difference and inter-group distribution difference of at least one process parameter.

9. The method as claimed in claim 8, wherein the at least one process parameter comprises critical dimension and/or edge placement error or other placement metric.

10. The method as claimed in any preceding claim, wherein the grouping step or first grouping step comprises:

    defining a pattern area;
    determining whether pattern feature have similar geometry within the pattern area; and
    grouping together those patterns which are determined to have similar geometry in the preceding step.

11. The method as claimed in any preceding claim, wherein the parameter of interest is edge placement error.

12. The method as claimed in any preceding claim, further comprising deriving a stochastic parameter based on assuming that all the pattern features of a group will behave similarly in terms of edge placement performance.

13. The method as claimed in any of claims 2 to 9, further comprising a step of dimensionality reduction of data comprising the one or more process attributes associated with the pattern features and wherein the step of grouping a plurality of pattern features is based on applying a clustering algorithm to the dimensionality reduced data.

14. The method as claimed in claim 13, wherein the step of dimensionality reduction is based on one of the following techniques: Principal Component Analysis (PCA), Singular Value Decomposition (SVD), encoder-decoder techniques, Variable Auto-Encoder (VAE), tSNE, or any other suitable non-linear mapping technique.

15. A computer program comprising program instructions operable to group pattern features of a substantially irregular pattern representation for patterning a substrate in a lithographic process, wherein the program instructions are configured, when run on a suitable apparatus, to:

    obtain at least one substantially irregular pattern representation, each at least one substantially irregular pattern representation relating to a respective layer of interest;
    group a plurality of pattern features comprised within the substantially irregular pattern representation based on geometry and/or at least one processing attribute relating to processing performance into a plurality of groups, each group comprising a plurality of pattern features which are similar in terms of geometry and/or the at least one processing attribute; and
derive a parameter of interest associated with one or more groups of the plurality of groups.

**Fig. 1**

**Fig. 2**

**Fig. 3**

**Fig. 4**

**Fig. 5**

**Fig. 6**

700

| 710 | ⇒ | 720 | ⇒ | 730 | ⇒ | 740 | ⇒ | 750 | ⇒ | 760 |

**Fig. 7**

800   810   820   830

**Fig. 8**

Europäisches
Patentamt

European
Patent Office

Office européen
des brevets

# EUROPEAN SEARCH REPORT

Application Number

EP 22 16 8094

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/002599 A1 (ASML NETHERLANDS BV [NL]) 6 January 2022 (2022-01-06) * paragraphs [0089], [0090], [0210] – [0214], [0249], [0250]; figure 14 * ----- | 1–15 | INV. G03F7/20 |
| A | US 2012/216156 A1 (LIU HUA-YU [US] ET AL) 23 August 2012 (2012-08-23) * paragraphs [0018], [0024] * ----- | 1–15 | |

TECHNICAL FIELDS
SEARCHED       (IPC)

G03F

The present search report has been drawn up for all claims

| Place of search | Date of completion of the search | Examiner |
|---|---|---|
| Munich | 6 October 2022 | Weckesser, Jens |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 16 8094

06-10-2022

| Patent document cited in search report | | Publication date | Patent family member(s) | | Publication date |
|---|---|---|---|---|---|
| WO 2022002599 | A1 | 06-01-2022 | TW | 202217462 A | 01-05-2022 |
| | | | WO | 2022002599 A1 | 06-01-2022 |
| US 2012216156 | A1 | 23-08-2012 | CN | 102053504 A | 11-05-2011 |
| | | | CN | 102054092 A | 11-05-2011 |
| | | | CN | 102597872 A | 18-07-2012 |
| | | | JP | 5156075 B2 | 06-03-2013 |
| | | | JP | 5433550 B2 | 05-03-2014 |
| | | | JP | 5666609 B2 | 12-02-2015 |
| | | | JP | 2011100121 A | 19-05-2011 |
| | | | JP | 2011100122 A | 19-05-2011 |
| | | | JP | 2013509604 A | 14-03-2013 |
| | | | KR | 20110046368 A | 04-05-2011 |
| | | | KR | 20120098754 A | 05-09-2012 |
| | | | TW | 201124871 A | 16-07-2011 |
| | | | TW | 201131287 A | 16-09-2011 |
| | | | TW | 201142488 A | 01-12-2011 |
| | | | US | 2011099526 A1 | 28-04-2011 |
| | | | US | 2011107280 A1 | 05-05-2011 |
| | | | US | 2012216156 A1 | 23-08-2012 |
| | | | US | 2013311958 A1 | 21-11-2013 |
| | | | US | 2016026750 A1 | 28-01-2016 |
| | | | WO | 2011051249 A1 | 05-05-2011 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A
- US 7695876 B
- WO 2016045901 A
- WO 2020169355 A
- WO 2020094286 A
- WO 2020173654 A
- WO 2021037484 A
- WO 2020233950 A
- WO 2019162346 A